# EUROPEAN PATENT APPLICATION

(11) **EP 2 216 796 A1**
(43) Date of publication of application: **11.08.2010**
(21) Application number: 09152117.9
(22) Date of filing: 05.02.2009
(51) Int. Cl.: H01H 15/06, H01H 1/40

(54) **Sliding contact assembly**

(71) Applicant: Delphi Technologies, Inc., Troy, Michigan 48007 (US)
(72) Inventor: Le Solleu, Jean-Pierre, 67000, Strasbourg (FR)
(74) Representative: Robert, Vincent

(57) **Abstract**

Sliding contact assembly (10) for low current applications comprising:
- a printed circuit board (14) including a substrate (16) on which is arranged at least one contact pad (18) made of several layers including a thin external layer (24) essentially made of gold, said gold layer (24) being deposited through a gold flash type process,
- a movable contact element (12) including a support member (26) having a contact surface (28) provided with a protective coating (30), said contact surface (28) being biased against said contact pad (18) when the movable contact element (12) is moved with regards to said contact pad (18),
**characterized in that** said protective coating (30) includes a palladium alloy layer (34).

## Description

### TECHNICAL FIELD

The present invention relates generally to sliding contact assemblies for low current applications.

### BACKGROUND OF THE INVENTION

The present invention relates more particularly to a sliding contact assembly to be implemented in a vehicle, for example in the column integrated module (CIM) arranged on the steering column of the vehicle, for electrical connection of switch devices.

Automotive suppliers use since decades Printed Circuit Boards with gold plating pads as direct contact interface for low current sliding contacts. Several gold plating processes are available on the market, providing various wear behavior.

Galvanic hard gold electroplated PCBs provide performance and contact reliability for low current applications, but galvanic hard gold electroplating is also the most expensive technology. This type of plating generates extra costs due to the quantity of gold necessary and due also to the process complexity.

In a cost driven industry, it is required to use a cheaper solution using standard low cost PCBs while still providing high reliability and good performances. To manufacture standard low cost PCBs with contact pads, several gold plating processes are available on the market including Electroless Nickel Immersion Gold (ENIG) and electrolytic pattern flash gold, these two processes providing a very thin layer of gold, generally lower than 0,150µm. These two types of gold plating process will be designated in the following description under the general term of "gold flash process" and PCBs comprising a protective layer of gold deposited according to a gold flash process will be named as gold flash PCBs.

Gold flash PCBs are generally designed to provide an oxidization/corrosion protection for the contact pads on the PCB to ensure a safe soldering of the electronic components. It is initially not designed as a contact interface.

Due to the very low thickness of gold deposited on the contact surface, the gold flash layer is not sufficient to provide long term reliable contact resistance without additional protection. Said gold flash layer is porous, and exhibits the underneath nickel layer through pores. It can generate an oxide and increase the electric contact resistance. To avoid corrosion or oxidization of the nickel, contact grease with specific protection properties is used.

The main problem with the use of gold flash PCBs is the wear behavior with an extreme sensitivity of gold even when hardened with cobalt or nickel.

Up to now, the contact sliders used in sliding contact assemblies are made of a bronze based contact spring which is electroplated with a nickel underlayer and a gold cobalt protective layer. When such gold plated contact sliders are used on gold flash PCBs, the lifetime is too short and some reliability problems can occur. To increase sliding contact assembly lifetime it is necessary to use a gold flash PCBs with very high requirements in term of roughness, in view to minimize friction at the contact interface. Such roughness requirements are very difficult to comply with and it increases PCB cost.

### SUMMARY OF THE INVENTION

The purpose of the present invention is to solve the above mentioned problem by providing a reliable and low cost solution to build sliding contact assemblies.

For this purpose, the present invention proposes a sliding contact assembly for low current applications comprising:
- a printed circuit board including a substrate on which is arranged at least one contact pad made of several layers including a thin external layer essentially made of gold, said gold layer being deposited through a gold flash type process,
- a movable contact element including a support member having a contact surface provided with a protective coating, said contact surface being biased against said contact pad when the movable contact element is moved with regards to said contact pad.

Said sliding contact assembly is **characterized in that** said protective coating includes a palladium alloy layer.

According to other features of the present invention:
- said contact pad gold layer has a thickness of 0.15 µm or less;
- said contact pad gold layer is deposited according to an Electroless Nickel Immersion Gold process;
- said palladium alloy comprises at least 60% of palladium;
- said palladium alloy comprises substantially between 70% and 90% of palladium and between 30% and 10% of nickel;
- said palladium alloy layer has a thickness between 1 and 3 µm;
- said protective coating includes a nickel underlayer on which said palladium alloy layer is deposited;
- said protective coating includes a gold layer which is deposited on said palladium alloy layer through a gold flash type process;
- said support member is made of copper alloy;
- a film of grease material is deposited above said contact pad in order to ease the sliding of said contact surface on said contact pad.

The present invention proposes also a manufacturing method for a sliding contact assembly for low current applications, comprising the following steps:
- providing a PCB substrate with at least one contact pad wherein the upper external layer is made essentially of gold deposited through a gold flash type process,
- providing a movable contact element including a support member having a contact surface to be biased against said contact pad,
- coating said contact surface with a protective coating,
- providing a film of grease material at the contact interface between said contact pad and said movable contact element.

Said manufacturing method is **characterized in that** said coating step includes forming a palladium alloy layer.

### BRIEF DESCRIPTION OF THE DRAWINGS

The present invention is now described by way of example with reference to the accompanying drawings in which:
- figure 1 is a schematic view showing a sliding contact assembly according to the present invention including a movable contact element;
- figure 2 is an enlarged cross-section view showing a portion of the contact surface of the movable contact element of figure 1.

### DESCRIPTION OF THE PREFERRED EMBODIMENTS

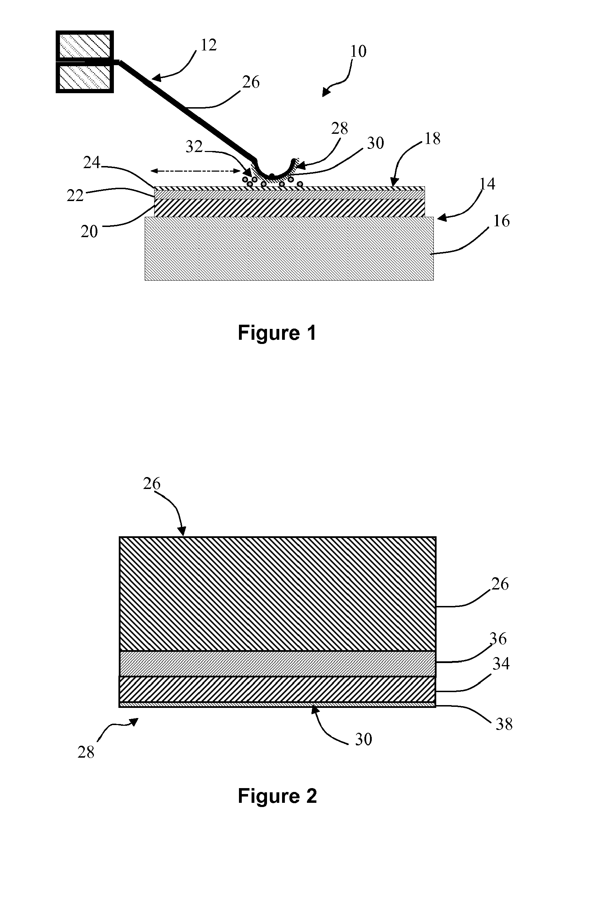

Figure 1 shows a sliding contact assembly 10 for low current applications built according to a preferred embodiment of the present invention. Said sliding contact assembly 10 includes a movable contact element 12 which is movable along a longitudinal direction X relatively to a printed circuit board 14.

Said printed circuit board 14 includes a substrate 16 on which is arranged at least one contact pad 18 made of several layers. According to the embodiment shown on figure 1, said contact pad 18 is constituted, from the upper surface of the substrate upwards of:
- a base layer 20 of copper, for example 35µm thick,
- an intermediate layer 22 of nickel, preferably 3 to 6µm thick,
- an external layer 24 essentially made of gold, preferably 0.15µm thick or less.

As can be seen, said external layer 24 of gold is made very thin, compared to the two other layers. It can be made of gold alloy hardened with cobalt (AuCo) or Nickel (AuNi)

Advantageously, said external layer 24 is deposited through a gold flash process, preferably an Electroless Nickel Immersion Gold process. Alternatively, it is deposited according to an Electrolytic Pattern Plating process.

Said movable contact element 12, or slider, comprises a support member 26 in the shape of a spring blade having a contact surface 28 provided with a protective coating 30 shown on figure 2. Thanks to the spring blade shape of the support member 26, said contact surface 28 is biased against the contact pad 18 of the PCB 14 when the movable contact element 12 is moved with regards to said contact pad 18.

Said support member 26 is preferably made of bronze (copper-tin alloy CuSn). Alternatively it could be made of another copper alloy such as copper-beryllium alloy or copper-nickel alloy.

Advantageously, a film 32 of grease material is deposited above said contact pad 18, at the contact interface between the contact pad 18 and the contact surface 28, in order to ease the sliding of said contact surface 28 on said contact pad 18. The grease is chosen in order to provide a good oxidization protection for the nickel underlayer 22 and to allow the contact functionality at temperatures down to -40°C. The grease material is preferably a perfluorpolyester (PFPE) based grease.

According to the present invention, said protective coating 30 on the contact surface 28 includes a layer 34 of palladium alloy comprising at least 60% of palladium. Advantageously, said palladium alloy is constituted substantially of 80% palladium and 20% nickel. Preferably, said layer 34 of palladium alloy has a thickness between 2 and 3 µm and it is deposited through an electrolytic process.

According to the preferred embodiment, said protective coating 30 includes an underlayer 36 of nickel on which said layer 34 of palladium alloy is deposited.

Optionally, said protective coating 28 includes an additional layer 38 of gold which is deposited on said layer 34 of palladium alloy through a gold flash type process. Said additional layer 38 is preferably 0.05µm to 0.1µm thick and has a cosmetic purpose as well as an oxidization protection purpose.

Endurance tests have been implemented with sliding contact assemblies 10 made according to the present invention and they have shown a significant improvement in wear resistance compared to sliding contact assemblies using gold for the protective coating instead of palladium alloy. The lifetime of the sliding contact assembly has been increased from a factor 200 on a given PCB.

Now a method for manufacturing a sliding contact assembly according to the present invention will be described. Said method comprises the following steps:
- providing a PCB substrate with at least one contact pad wherein the upper external layer is made essentially of gold deposited through a gold flash type process,
- providing a movable contact element including a support member having a contact surface to be biased against said contact pad,
- coating said contact surface with a protective coating,
- providing a film of grease material at the contact interface between said contact pad and said movable contact element.

According to the present invention, said coating step comprises the following steps:
- plating said contact surface with an underlayer of nickel,
- plating said underlayer of nickel with a layer of palladium alloy.

Optionally, it can comprise an additional step of plating said layer of palladium with an additional layer of gold through a gold flash type process.

## Claims

1. Sliding contact assembly (10) for low current applications comprising:
- a printed circuit board (14) including a substrate (16) on which is arranged at least one contact pad (18) made of several layers including a thin external layer (24) essentially made of gold, said gold layer (24) being deposited through a gold flash type process,
- a movable contact element (12) including a support member (26) having a contact surface (28) provided with a protective coating (30), said contact surface (28) being biased against said contact pad (18) when the movable contact element (12) is moved with regards to said contact pad (18),
**characterized in that** said protective coating (30) includes a palladium alloy layer (34).

2. Assembly (10) according to claim 1, **characterized in that** said contact pad gold layer (24) has a thickness of 0.15 µm or less.

3. Assembly (10) according to claim 1 or 2, **characterized in that** said contact pad gold layer (24) is deposited according to an Electroless Nickel Immersion Gold process.

4. Assembly (10) according to anyone of the preceding claims, **characterized in that** said palladium alloy comprises at least 60% of palladium.

5. Assembly (10) according to claim 4, **characterized in that** said palladium alloy comprises substantially between 70% and 90% of palladium and between 30% and 10% of nickel.

6. Assembly (10) according to anyone of the preceding claims, **characterized in that** said palladium alloy layer (34) has a thickness between 2 and 3 µm

7. Assembly (10) according to anyone of the preceding claims, **characterized in that** said protective coating (30) includes a nickel underlayer on which said palladium alloy layer (34) is deposited.

8. Assembly (10) according to anyone of the preceding claims, **characterized in that** said protective coating (30) includes a gold layer (38) which is deposited on said palladium alloy layer (34) through a gold flash type process.

9. Assembly (10) according to anyone of the preceding claims, **characterized in that** said support member (26) is made of copper alloy.

10. Assembly (10) according to anyone of the preceding claims, **characterized in that** a film (32) of grease material is deposited above said contact pad (18) in order to ease the sliding of said contact surface (28) on said contact pad (18).

11. Manufacturing method for a sliding contact assembly (10) for low current applications, comprising the following steps:
- providing a PCB substrate (16) with at least one contact pad (18) wherein the upper external layer (24) is made essentially of gold deposited through a gold flash type process,
- providing a movable contact element (12) including a support member (26) having a contact surface (28) to be biased against said contact pad (18),
- coating said contact surface (28) with a protective coating (30),
- providing a film (32) of grease material at the contact interface between said contact pad (18) and said movable contact element (12).
**characterized in that** said coating step includes forming a palladium alloy layer (34).
